# EUROPEAN PATENT APPLICATION

(11) **EP 2 442 370 A2**
(43) Date of publication of application: **18.04.2012**
(21) Application number: 10196199.3
(22) Date of filing: 21.12.2010
(51) Int. Cl.: H01L 31/048, H01L 31/052

(54) **Package structure of concentrated photovoltaic cell**

(30) Priority: 14.10.2010 US 904253
(71) Applicant: Millenium Communication Co., Ltd, Hsinchu Industrial Park Hsinchu Hsien 30351 (CN)
(72) Inventor: Chang, Yi-An, 30351, Hsinchu Hsien (TW); Lai, Li-Hung, 30351, Hsinchu Hsien (TW)
(74) Representative: Viering, Jentschura & Partner

(57) **Abstract**

A package structure of a concentrated photovoltaic cell includes a ceramic base plate whereon a cavity is formed, the cavity having two opposite internal walls respectively having staircase structures, each having an upper step and a lower step; a photovoltaic chip disposed on a bottom surface of the cavity; a first electrode circuit path penetrating the ceramic base plate and with a top end electrically connected to the photovoltaic chip; a second electrode circuit path penetrating the lower steps on the two sides of the ceramic base plate and connecting with the photovoltaic cell through metal wires; and a transparent cover disposed on the upper steps for covering the cavity and the photovoltaic chip. A fabrication method for the aforementioned package structure is also provided. The aforementioned package structure has the advantages of being more efficient in heat dissipation and effective in protecting the photovoltaic chip.

## Description

### BACKGROUND OF THE INVENTION

### 1. FIELD OF THE INVENTION

The present invention relates to a package structure of a concentrated photovoltaic cell, and more particularly to a package structure of a concentrated photovoltaic chip using a ceramic base plate with staircase structures enclosing the photovoltaic chip to increase the heat dissipation efficiency.

### 2. DESCRIPTION OF THE PRIOR ART

A concentrated photovoltaic cell primarily uses lenses to focus the sunlight to a small area to enhance power generation efficiency. When a concentrated photovoltaic cell is used for electrical energy conversion, because the material of the photovoltaic cell itself has limited absorption capability for light spectrum, it cannot 100% convert the light energy into electrical energy for output. As a result, the remaining energy left in the photovoltaic cell tend to become heat accumulated in the cell, causing the temperature of the component to rise, leading to the internal dark current of the cell to soar and the conversion efficiency of the cell to decrease.

In a package structure of a photovoltaic cell, the photovoltaic chip is usually directly attached to a circuit board, and electrically connected to the circuit board by means of wire bonding. And the package structure is injected with epoxy resin to isolate the photovoltaic chip from the external environment. However, the thermal expansion coefficients of the epoxy resin, photovoltaic chip and circuit board are substantially different, and therefore after the cell is being used for a while, the epoxy resin may be eroded by moisture and detach from the circuit board, causing the photovoltaic chip to be exposed, and the lifespan of the photovoltaic chip to be affected. Besides, the difference between the thermal expansion coefficients of the photovoltaic chip and the circuit board may cause the heat dissipation efficiency of the photovoltaic chip to decrease.

### SUMMARY OF THE INVENTION

In order to solve the aforementioned problems, the present invention is directed to providing a package structure of a concentrated photovoltaic cell and the fabrication method thereof. The package structure of the concentrated photovoltaic cell has the advantages of being more efficient in heat dissipation and effective in protecting the photovoltaic chip.

In order to achieve the aforementioned objectives, a package structure of a concentrated photovoltaic cell according to an embodiment of the present invention includes a ceramic base plate having an upper surface and a lower surface, the upper surface having a cavity disposed thereon, and the cavity having a bottom surface; at least two opposite internal side walls of the cavity respectively having staircase structures formed thereon, each of the staircase structures comprising two steps respectively an upper step and lower step; a first electrode circuit path penetrating the ceramic base plate and with a top end and bottom end exposed at the bottom surface of the cavity and the lower surface of the ceramic base plate, respectively; a second electrode circuit path penetrating the ceramic base plate and with a top end and a bottom end exposed at a surface of the lower step and the lower surface of the ceramic base plate, respectively; a photovoltaic chip disposed on the bottom surface of the cavity, and electrically connected to the top end of the first electrode circuit path; an electrical connecting structure electrically connecting the photovoltaic chip and the second electrode circuit path; and a transparent cover disposed on a surface of the upper step for covering the cavity and the photovoltaic chip.
The fabrication method of the package structure of the concentrated photovoltaic cell according to another embodiment includes providing a ceramic base plate having an upper surface and a lower surface; forming a cavity on the upper surface of the ceramic base plate, the cavity having a bottom surface; forming staircase structures respectively on at least two opposite internal side walls of the cavity; forming a first electrode circuit path in the ceramic base plate such that the first electrode circuit path penetrates through the ceramic base plate and a top end and bottom end of the first electrode circuit path are exposed at the bottom surface of the cavity and the lower surface of the ceramic base plate, respectively; forming a second electrode circuit path in the ceramic base plate such that the second electrode circuit path penetrates through the ceramic base plate, and a top end and a bottom end of the second electrode circuit path are exposed at a surface of the staircase structure and the lower surface of the ceramic base plate, respectively; disposing a photovoltaic chip on the bottom surface of the cavity, and electrically connecting the photovoltaic chip to the top end of the first electrode circuit path; electrically connecting the photovoltaic chip to the second electrode circuit path; and disposing a transparent cover for covering the cavity and the photovoltaic chip.

The objective, technologies, features and advantages of the present invention will become more apparent from the following description in conjunction with the accompanying drawings, wherein certain embodiments of the present invention are set forth by way of illustration and examples.

### BRIEF DESCRIPTION OF THE DRAWINGS

FIG. 1 schematically illustrates a sectional view of the package structure of the concentrated photovoltaic cell according to the first embodiment of the present invention;

FIG. 2 schematically illustrates a front view of FIG. 1.

FIG. 3 schematically illustrates a sectional view of the application of the package structure of the concentrated photovoltaic cell according to the first embodiment of the present invention;

FIG. 4 schematically illustrates a front view of the ceramic base plate according to an embodiment of the present invention;

FIG. 5 schematically illustrates a sectional view of the package structure of the concentrated photovoltaic cell according to the second embodiment of the present invention; and

FIG. 6A to FIG. 6D schematically illustrates sectional views of the fabrication method of the package structure of the concentrated photovoltaic cell.

### DESCRIPTION OF THE PREFERRED EMBODIMENT

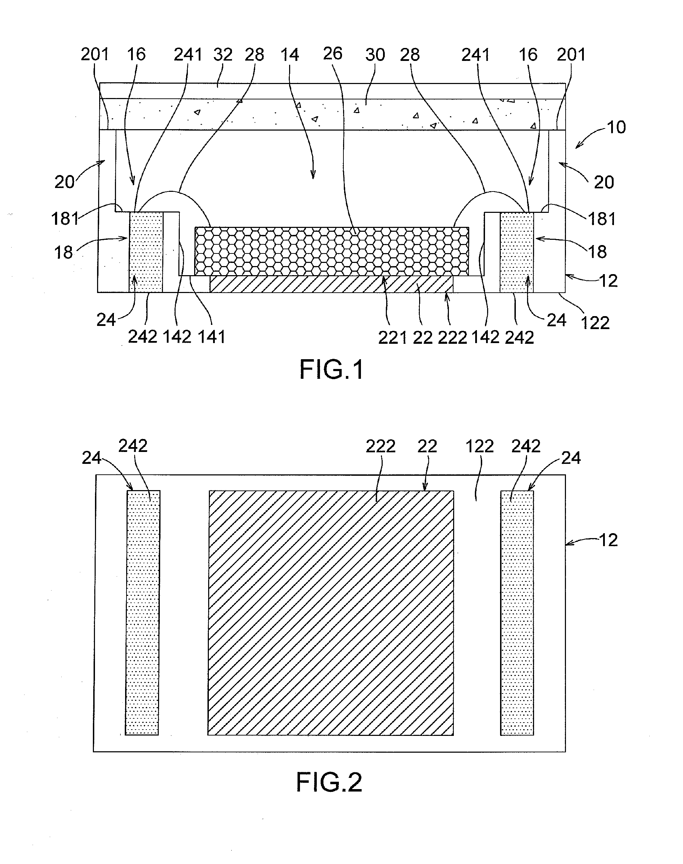

FIG. 1 schematically illustrates a sectional view of a package structure of a concentrated photovoltaic cell according to an embodiment. In the present embodiment, the package structure 10 includes a ceramic base plate 12 having an upper surface (not indicated) whereon a cavity 14 having a bottom surface 141 and four internal side walls 142 surrounding the bottom surface 141 is disposed and a lower surface 122; two of the opposite internal side walls 142 of the cavity 14 respectively having staircase structures 16, each including two steps, respectively a lower step 18 and an upper step 20, formed thereon; a first electrode circuit path 22, shown as well in FIG. 2, disposed at the central area of the ceramic base plate 12, and penetrating vertically through the ceramic base plate 12 to expose its top end 221 and bottom end 222 at the bottom surface 141 of the cavity 14 and the lower surface 122 of the ceramic base plate 12, respectively; a second electrode circuit path 24, shown as well in FIG. 2, disposed at the lower step 18 areas on the two sides, and being therefore located on the two sides of the first electrode circuit path 22 and penetrating vertically through the ceramic base plate 12 to expose its top end 241 and bottom end 242 at the surface 181 of the lower step 18 and the lower surface 122 of the ceramic base plate 12, respectively; a photovoltaic chip 26 disposed on the bottom surface 141 of the cavity 14 and electrically connected to the exposed top end 221 of the first electrode circuit path 22; an electrical connecting structure 28 electrically connecting the photovoltaic chip 26 and the second electrode circuit path 24; and a transparent cover 30 disposed on the surfaces 201 of the upper steps 20 on the two sides for covering the cavity 14 and the photovoltaic chip 26.

The electrodes of the first electrode circuit path 22 and the second electrode circuit path 24 are different. In the present embodiment, the electrodes of the first electrode circuit path 22 and the second electrode circuit path 24 are respectively anode and cathode. Also, the first electrode circuit path 22 and the second electrode circuit path 24 are usually made of copper, and is arranged penetrating the ceramic base plate 12 by means of embedding or electroplating. The photovoltaic chip 26 includes a bottom surface electrode (not illustrated in the figure) and two surface electrodes (not illustrated in the figure). The photovoltaic chip 26 is disposed on the bottom surface 141 of the cavity 14 by means of die bonding, and the bottom surface electrode of the photovoltaic chip 26 is electrically connected to the exposed top end 221 of the first electrode circuit path 22. Also, the aforementioned electrical connecting structure 28 may be a plurality of metal wires electrically connecting the surface electrode of the photovoltaic chip 26 and the exposed top end 241 of the second electrode circuit path 24 by means of wire bonding.

Continuing the above description, the transparent cover 30 is a glass, which facilitates the concentrated light from the concentrating lenses (not illustrated in the figure) to pass through and be focused on the photovoltaic chip 26. The photovoltaic chip 26 absorbs the incident light from the concentrating lenses and converts it to electrical energy for output. In between the transparent cover 30 and the photovoltaic chip 26 lies a gap which may be filled with ethyl vinyl acetate (EVA) resin, injected with nitrogen gas or pumped to a vacuum state. Besides, there may be an anti-reflective coating 32 disposed on the upper surface, lower surface or both of the transparent cover 30 so as to reduce the probability that the light having entered the package structure 10 is reflected out, thereby further enhancing the optoelectric conversion efficiency.

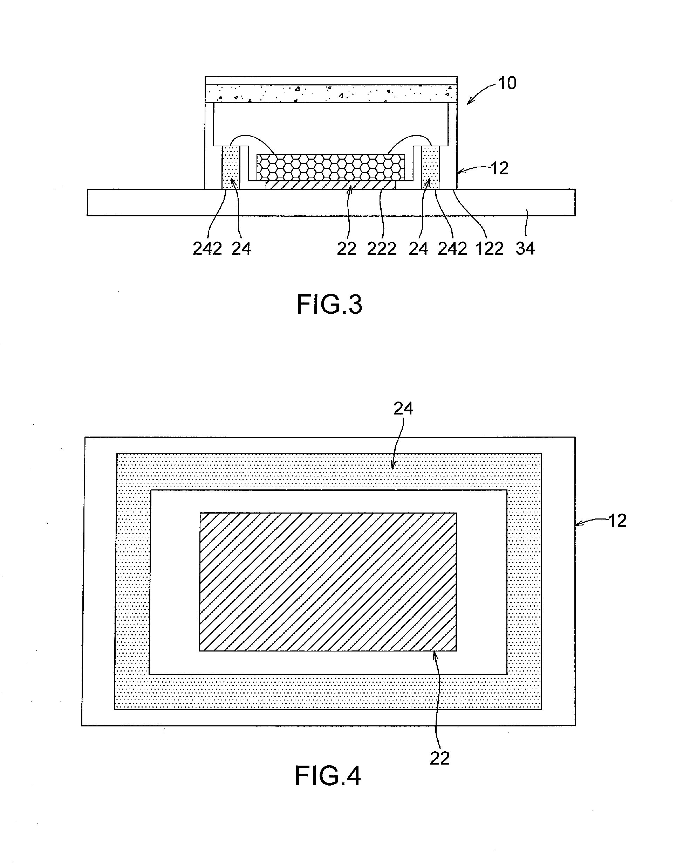

As shown in FIG. 3, when the package structure of the concentrated photovoltaic cell 10 is applied, the ceramic base plate 12 is fixed on a metal substrate 34 with a larger area. The metal substrate 34 is commonly made of aluminum or copper, and has printed circuits (not shown in the figure) formed thereon that contains circuit patterns corresponding to the first electrode circuit path 22 and the second electrode circuit path 24. By fixing the ceramic base plate 12 on the metal substrate 34, the bottom end 222, 224 of the first and second electrode circuit path 22, 24 exposed at the lower surface 122 of the ceramic base plate 12 may contact with the circuit patterns, whereby the electrical energy converted by the photovoltaic chip 26 can be transmitted out.

In the present invention, the pattern of the second electrode circuit path 24 aside from being placed on the two sides of the first electrode circuit path 22 as shown in FIG. 2, may also be embedded around the periphery of the ceramic base plate 12 as shown in FIG. 4; in such way, the area of the second electrode circuit path 24 increases, and the second electrode circuit path 24 may therefore be able to sustain higher amount of current.

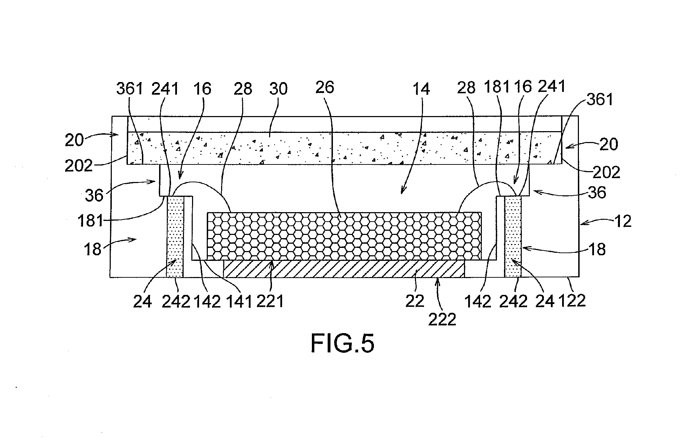

Additionally, in the present invention, the number of steps in the staircase structure 16 is not limited to two. FIG. 5 schematically illustrates a sectional view of the package structure of the concentrated photovoltaic cell in accordance with a second embodiment. As illustrated in the figure, each of the staircase structures 16 formed on the two opposite internal side walls 142 of the cavity 14 of the ceramic base plate 12 includes three steps, respectively a lower step 18, middle step 36 and upper step 20. The first electrode circuit path 22 is disposed at the central area of the ceramic base plate 12 and penetrates through the ceramic base plate 12 vertically to expose its top end 221 and bottom end 222 at the bottom surface 141 of the cavity 14 and the lower surface 122 of the ceramic base plate 12. The second electrode circuit path 24 is disposed on the lower step 18 areas on the two sides, so that the second electrode circuit path 24 is located on the two sides of the first electrode circuit path 22. The second electrode circuit path 24 penetrates vertically through the ceramic base plate 12 to expose its top end 241 and bottom end 242 at the surface 181 of the lower step 18 and the lower surface 122 of the ceramic base plate 12. The photovoltaic chip 26 is disposed on the bottom surface of the cavity 14 and is electrically connected to the exposed top end 221 of the first electrode circuit path 22. The electrical connecting structure 28 electrically connects the photovoltaic chip 26 and the second electrode circuit path 24. And the transparent cover is disposed on the surfaces of the middle steps 26 on the two sides for covering the cavity 14 and the photovoltaic chip 26. The difference between the second embodiment and the first embodiment is the location where the transparent cover 30 is disposed. In the second embodiment, the transparent cover 30 is disposed on the surfaces 361 of the middle steps 36 on the two sides, and thus the two side surfaces of the transparent cover 30 may be covered by the vertical faces of the upper steps 20, thereby providing a better degree of fixity.

In the present invention, since the photovoltaic chip is disposed in the cavity of the ceramic base plate, it is enclosed by the ceramic base plate and has larger contacting area with the ceramic base plate. Consequently, the heat dissipation effect for the photovoltaic chip is better. In addition, the protection from the transparent cover may isolate the photovoltaic chip from the external moisture or air for long-term, effectively protecting the photovoltaic chip and preventing adverse impacts to the optoelectric conversion efficiency and lifespan of the photovoltaic chip.

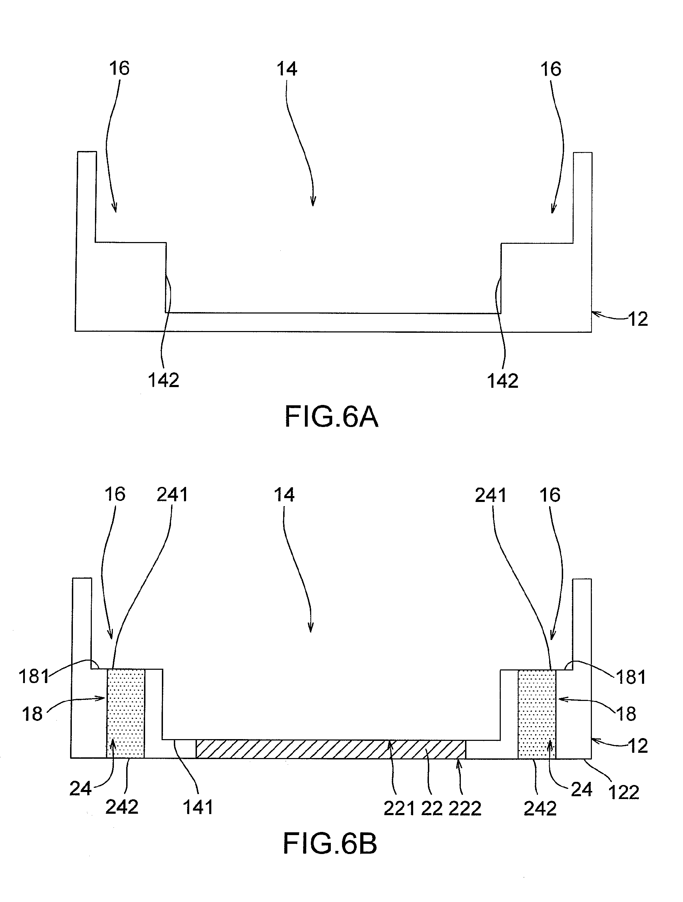

FIG. 6A to FIG. 6D schematically illustrate sectional views of the fabrication method of the package structure of the concentrated photovoltaic cell according to an embodiment. As illustrated in FIG. 6A, a ceramic base plate 12 is first provided, and a cavity is formed on an upper surface of the ceramic base plate 12. Staircase structures 16 are formed on two opposite internal side walls 142 of the cavity 12, respectively. In an embodiment, the cavity 14 and the staircase structure 16 are of one piece form.

Next, as illustrated in FIG. 6B, a first electrode circuit path 22 and a second electrode circuit path 24 are formed on the ceramic base plate 12, such that the first electrode circuit path 22 and the second electrode circuit path penetrate through the ceramic base plate 12. The first electrode circuit path 22 penetrates vertically through a central area of the ceramic base plate 12, and a top end 221 and bottom end 222 of the first electrode circuit path 22 are exposed at the lower surface 141 of the cavity 14 and the lower surface 122 of the ceramic base plate 12. The second electrode circuit path 24 penetrates vertically through the staircase structures 16 and are located on the two sides of the first electrode circuit path 22. A top end 241 and bottom end 243 of the second electrode circuit path 24 are exposed at a surface 181 of the lower step 18 of the staircase structure 16 and a lower surface 122 of the ceramic base plate 12, respectively. In one embodiment, the first electrode circuit path 22 and the second electrode circuit path are formed in the ceramic base plate 12 by means of electroplating or embedding.

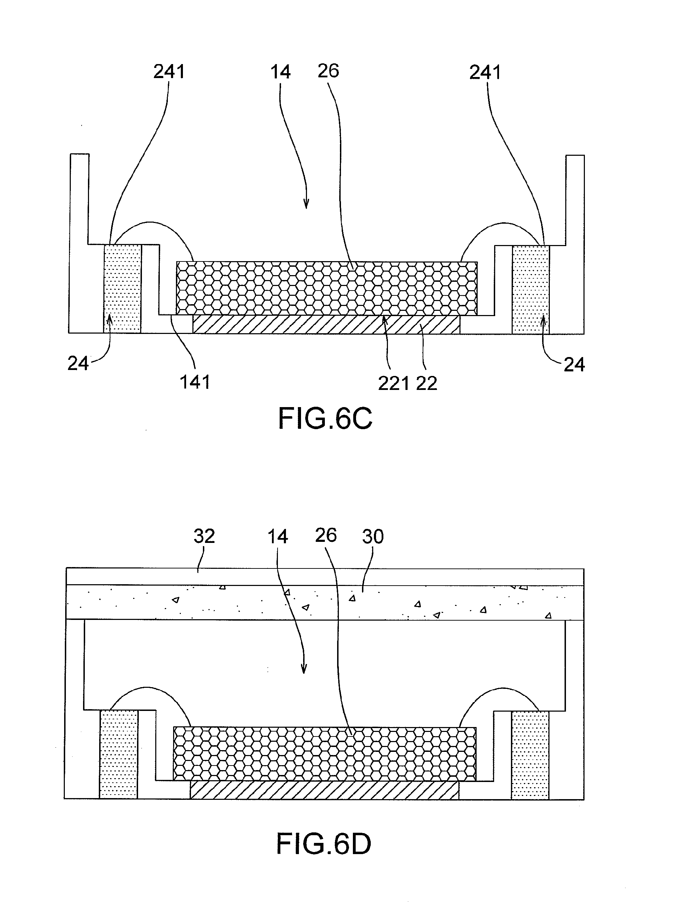

Thereafter, as illustrated in FIG. 6C, a photovoltaic chip 26 is disposed on a bottom surface 141 of the cavity 14, and a bottom electrode of the photovoltaic chip 26 (not illustrated in the figure) is electrically connected to the exposed top end 221 of the first electrode circuit path 22, and surface electrodes (not illustrated in the figure) of the photovoltaic chip 26 are electrically connected to the exposed top ends 241 of the second electrode circuit path 24 by means of wire bonding.

Lastly, as illustrated in FIG. 6D, a transparent cover 30 for covering the cavity 14 and the photovoltaic chip 26 is disposed. Further, the gap between the transparent cover and the photovoltaic chip 26 may further be filled with ethyl vinyl acetate (EVA) resin, injected with nitrogen gas or pumped to a vacuum state. In addition, an anti-reflective coating may be disposed on the upper surface, lower surface or both of the transparent cover 30 so as to reduce the probability that the light having entered the package structure 10 is reflected out, thereby further enhancing the optoelectric conversion efficiency

While the invention is susceptible to various modifications and alternative forms, a specific example thereof has been shown in the drawings and is herein described in detail. It should be understood, however, that the invention is not to be limited to the particular form disclosed, but to the contrary, the invention is to cover all modifications, equivalents, and alternatives falling within the spirit and scope of the appended claims.

## Claims

1. A package structure of a concentrated photovoltaic cell comprising:
a ceramic base plate having an upper surface and a lower surface, the upper surface having a cavity disposed thereon, and the cavity having a bottom surface;
at least two opposite internal side walls of the cavity respectively having staircase structures formed thereon, each of the stair case structures comprising two steps respectively an upper step and lower step;
a first electrode circuit path penetrating the ceramic base plate and with a top end and bottom end exposed at the bottom surface of the cavity and the lower surface of the ceramic base plate, respectively;
a second electrode circuit path penetrating the ceramic base plate and with a top end and a bottom end exposed at a surface of the lower step and the lower surface of the ceramic base plate, respectively;
a photovoltaic chip disposed on the bottom surface of the cavity, and electrically connected to the top end of the first electrode circuit path;
an electrical connecting structure electrically connecting the photovoltaic chip and the second electrode circuit path; and
a transparent cover disposed on a surface of the upper step for covering the cavity and the photovoltaic chip.

2. The package structure of the concentrated photovoltaic cell according to claim 1, wherein the first electrode circuit path and the second electrode circuit path are different.

3. The package structure of the concentrated photovoltaic cell according to claim 2, wherein the electrode of the first electrode circuit path is the anode, and the electrode of the second electrode circuit path is the cathode.

4. The package structure of the concentrated photovoltaic cell according to claim 1, wherein the second electrode circuit path penetrates through the lower step of the ceramic base plate, and is located on the two sides of the first electrode circuit path.

5. The package structure of the concentrated photovoltaic cell according to claim 1, wherein the second electrode circuit path penetrates through the ceramic base plate and is arranged to surround the periphery of the first electrode circuit path.

6. The package structure of the concentrated photovoltaic cell according to claim 4, wherein the photovoltaic chip comprises a bottom surface electrode and at least two surface electrodes, the bottom surface electrode is electrically connected to the first electrode circuit path, and the two surface electrodes are electrically connected to the second electrode circuit path.

7. The package structure of the concentrated photovoltaic cell according to claim 5 wherein the photovoltaic chip comprises a bottom surface electrode and at least two surface electrodes, the bottom surface electrode is electrically connected to the first electrode circuit path, and the two surface electrodes are electrically connected to the second electrode circuit path.

8. The package structure of the concentrated photovoltaic cell according to claim 1, wherein the transparent cover is a glass.

9. The package structure of the concentrated photovoltaic cell according to claim 1, wherein a gap between the transparent cover and the photovoltaic chip is filled with ethyl vinyl acetate (EVA) resin, injected with nitrogen gas or pumped to a vacuum state.

10. The package structure of the concentrated photovoltaic cell according to claim 1, further comprising an anti-reflective coating disposed on an upper surface, a lower surface or both of the transparent cover.

11. The package structure of the concentrated photovoltaic cell according to claim 1, wherein the electrical connecting structure are a plurality of conductive wires electrically connecting the
photovoltaic chip and the second electrode circuit path.
